(19)

Europäisches Patentamt
European Patent Office
Office européen des brevets

(11) **EP 4 046 962 A1**

(12) **EUROPEAN PATENT APPLICATION**
published in accordance with Art. 153(4) EPC

(43) Date of publication:
**24.08.2022 Bulletin 2022/34**

(21) Application number: **20877552.8**

(22) Date of filing: **07.10.2020**

(51) International Patent Classification (IPC):
***C01B 33/12*** (2006.01) ***B01J 13/00*** (2006.01)

(52) Cooperative Patent Classification (CPC):
**B01J 13/00; C01B 33/12**

(86) International application number:
**PCT/JP2020/037967**

(87) International publication number:
**WO 2021/075323 (22.04.2021 Gazette 2021/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **15.10.2019 JP 2019188961**

(71) Applicants:
• **Public University Corporation Nagoya City University Mizuho-ku Nagoya-shi Aichi 467-8601 (JP)**
• **Murata Manufacturing Co., Ltd. Nagaokakyo-shi, Kyoto 617-8555 (JP)**

(72) Inventors:
• **YAMANAKA Junpei Nagoya-shi, Aichi 467-8603 (JP)**
• **TOYOTAMA Akiko Nagoya-shi, Aichi 467-8603 (JP)**
• **OKUZONO Tohru Nagoya-shi, Aichi 467-8603 (JP)**
• **FUJITA Minori Nagoya-shi, Aichi 467-8603 (JP)**
• **AOYAMA Yurina Nagoya-shi, Aichi 467-8603 (JP)**
• **MINAMI Madoka Nagoya-shi, Aichi 467-8603 (JP)**

(74) Representative: **Reeve, Nicholas Edward Reddie & Grose LLP The White Chapel Building 10 Whitechapel High Street London E1 8QS (GB)**

(54) **COLLOIDAL CRYSTALS HAVING DIAMOND LATTICE STRUCTURE AND METHOD FOR PRODUCING SAME**

(57) [Problems] A problem to be solved is at least one of (1) to provide a colloidal crystal having a diamond lattice structure and composed of colloidal particles having an average particle diameter of 50 nm or more, and (2) to provide a method capable of easily producing a colloidal crystal having a diamond lattice structure.

A colloidal crystal having a diamond lattice structure, including: a first layer in which a first plurality of particles are arranged to form a plane of a face-centered cubic lattice structure; a second layer in which a second plurality of particles are arranged on the first layer in contact with the first particles; and a third layer in which a third plurality of particles are arranged on the second layer in contact with the second particles, wherein the colloidal crystal includes at least one layer of each of the first layer, the second layer and the third layer.

FIG. 7

## Description

FIELD OF THE INVENTION

The present invention relates to a colloidal crystal having a diamond lattice structure and a method for producing the same.

BACKGROUND OF THE INVENTION

A colloid is a state in which a dispersed phase is dispersed in a medium and is referred to as a colloidal dispersion when the medium is liquid. As used in this description, the dispersed phase is composed of solid colloidal particles. When appropriate conditions are selected, the colloidal particles spontaneously assemble in the colloidal dispersion to form various ordered structures called colloidal crystals with a regular arrangement.

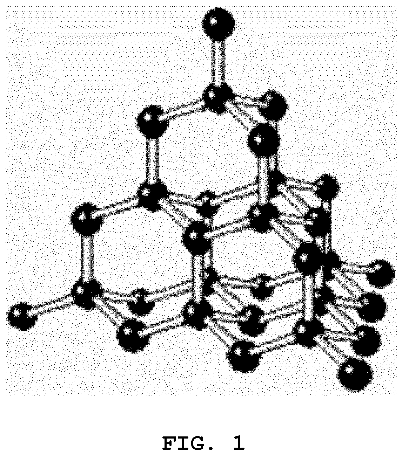

The colloidal particles in colloidal crystals have a particle diameter ranging from nanometer order to micrometer order and an arrangement structure with a spatial period of the same degree. Since particles of several hundred nm and their arrangements scatter and diffract visible light, research has been conducted to apply colloidal crystals as optical materials. In particular, it has been clarified that a diamond lattice structure having a structural period on the order of the wavelength of light (see FIG. 1) functions as a three-dimensional photonic crystal having a perfect bandgap capable of confining light (Nonpatent Literature 1). Therefore, research is actively conducted on colloidal crystals in this field. It has recently been reported that a complete bandgap is also generated in a disordered diamond lattice structure (amorphous diamond lattice structure) or a single-layer diamond lattice structure.

Methods for producing a diamond lattice structure using electron beam lithography or precision drilling are known. However, with these physical processing methods, only small structures can be obtained, and it is difficult to produce a thick three-dimensional diamond lattice structure. Therefore, attempts to produce a diamond lattice structure by self-assembly of colloidal particles have attracted worldwide attention.

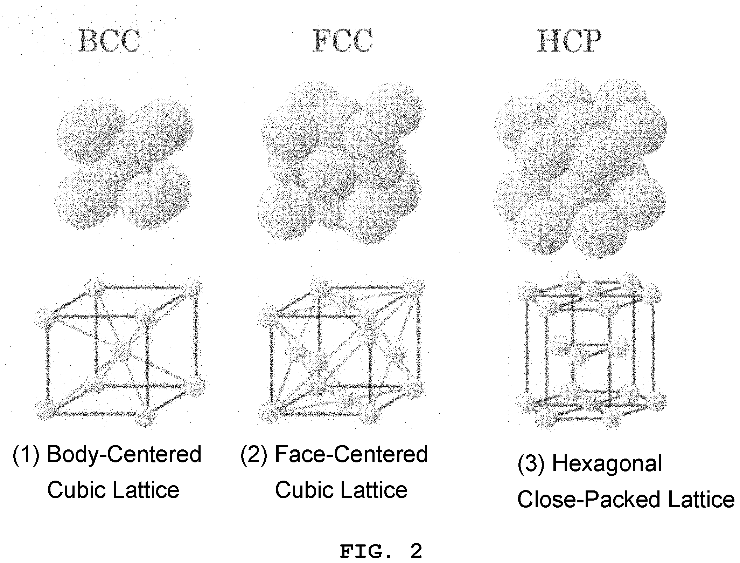

However, when isotropic interactions work in a one-component spherical particle colloidal system, the self-assembled colloidal crystal has either a face-centered cubic lattice structure, a body-centered cubic lattice structure, or a hexagonal close-packed lattice structure (see FIG. 2), and a diamond lattice structure cannot be obtained (Nonpatent Literature 2). When the closest colloidal particles are in contact with each other, the particles of the face-centered cubic lattice have an atomic packing factor of 74 %, while the particles of the diamond lattice structure have an atomic packing factor of 34 %. Such a diamond lattice structure having many voids is entropically disadvantageous and mechanically unstable (Nonpatent Literature 3).

On the other hand, it has been proposed to utilize electrostatic interaction to form a diamond lattice structure with a two-component colloidal system (Nonpatent Literature 4). Since the electrostatic interaction works over a long distance, a diamond lattice structure with large voids may be obtained by using the electrostatic interaction. It has been reported that a large crystal (micrometer size) having a diamond-like lattice structure (ZnS type) is generated in a two-component system of positively and negatively charged metal nanoparticles of about 5 nm (Nonpatent Literature 4). However, when the particle diameter of the colloidal particles is nano-sized or larger, the reach of the electrostatic interaction is relatively short as compared to the particle diameter, which makes it difficult to apply this method (Nonpatent Literature 3).

Therefore, colloidal crystals having a diamond lattice structure composed of colloidal particles having an average particle diameter of at least 50 nm cannot be obtained using known methods. Current methods are also unable to produce colloidal crystals having a two-dimensional diamond lattice structure consisting of only a single layer.

As techniques related to the present invention, the present inventors have reported a method for producing a two-dimensional crystal by adsorbing a three-dimensional charged colloid (see Nonpatent Literature 5) and research on conditions for forming a tetrahedral cluster (Nonpatent Literature 6).

PRIOR ART DOCUMENT

Non-Patent Literature

Nonpatent Literature 1: K. M. Ho, C. T. Chan, and C. M. Soukoulis, Phys.Rev.Lett., 65, 3152 (1990)
Nonpatent Literature 2: M. Maldovan, and E. L.Thomas, Nature Mater., 3, 593(2004)
Nonpatent Literature 3: E.Ducrot, M.He, G.Yi, and D.J.Pine, Nature Mater., 16, 652(2017)
Nonpatent Literature 4: A.M.Kalsin, M.Fialkowski, M.Paszewski, S.K.Smoukov, K.J.M.Bishop, and B.A. Grzybowski, Science, 312,420(2006)

Nonpatent Literature 5: Y. Aoyama, A. Toyotama, T. Okuzono, J. Yamanaka, Langmuir, 35, 9194 (2019)
Nonpatent Literature 6: Y. Nakamura, M. Okachi, A. Toyotama, T. Okuzono, and J.Yamanaka, Langmuir, 31, 13303 (2015)

## SUMMARY OF THE INVENTION

### Problem to Be Solved by the Invention

In view of the shortcomings of known methods for producing colloidal crystals, there exists a need for (1) a colloidal crystal having a diamond lattice structure and composed of colloidal particles having an average particle diameter of at least 50 nm, and (2) a method capable of easily producing a colloidal crystal having a diamond lattice structure.

### Means for Solving Problem

In a first aspect, the present invention provides a colloidal crystal having a diamond lattice structure, comprising: a first layer in which a first plurality of particles are arranged to form a (111) plane of a face-centered cubic lattice structure; a second layer in which a second plurality of particles are arranged on the first layer in contact with the first particles; and a third layer in which a third plurality of particles are arranged on the second layer in contact with the second plurality of particles, wherein the colloidal crystal comprises one layer of each of the first layer, the second layer and the third layer, or comprises a structure in which at least one of these layers are repeated.

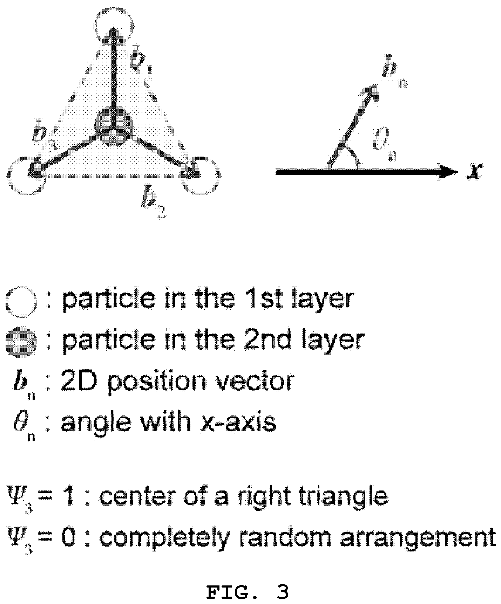

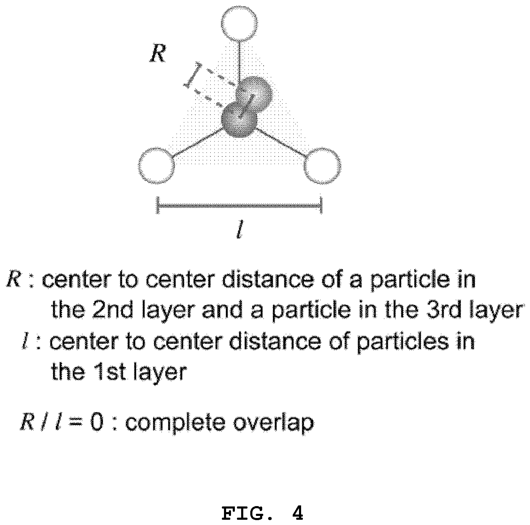

As used herein, the term "diamond lattice structure" includes not only a face-centered cubic lattice structure in which particles forms a complete regular tetrahedron, but also a face-centered cubic lattice structure composed of distorted regular tetrahedrons. A degree of distortion can be evaluated by an orientation order parameter $\Psi_3$ defined by Equation (1) below and a value of $R/\ell$ defined by Equation (2) below. In Equation (1), $\theta_n$ denotes an angle formed by a vector from a center of a particle in the second layer toward a center of three particles in the first layer, and an arbitrary set reference axis (see FIG. 3). In Equation (2), $\ell$ denotes a distance between particles forming an equilateral triangle in the first layer (i.e., the length of one side of the equilateral triangle), and R denotes a distance representing how much a particle in the third layer is deviated from the perfect diamond lattice structure with respect to a particle in the second layer (see FIG. 4).

[Math. 1]

$$\psi_3 = \frac{1}{3}\sum_{n=1}^{3}\left|e^{-3i\theta_n}\right| \quad \cdots (1)$$

$$R/\ell \quad \cdots (2)$$

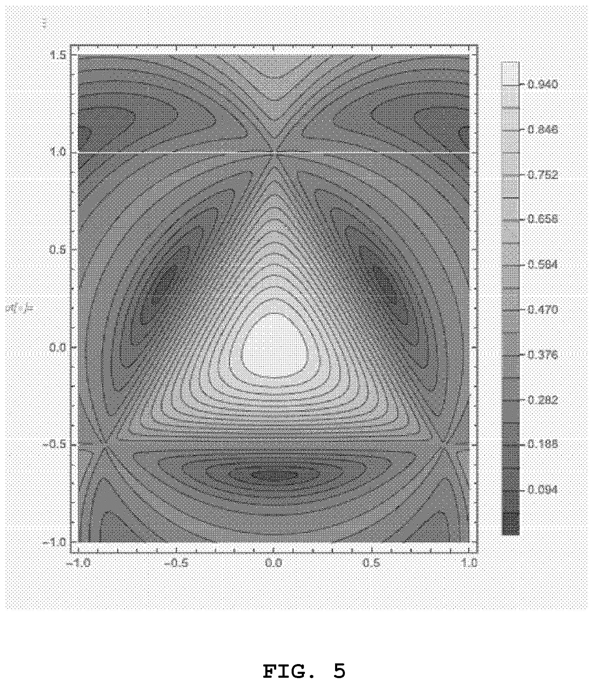

FIG. 5 is a graph showing a relationship between a value of the orientational order parameter $\Psi_3$ and a position of a particle. This graph shows changes in $\Psi_3$ due to positions of particles in the second layer by contour lines when a particle of the first layer is present at each vertex of an equilateral triangle. Numerical values on the right side of the graph show the relationship between a color tone and $\Psi_3$ (e.g., a central region of the equilateral triangle has $\Psi_3$ of 0.940 or more). In a strain-free diamond lattice structure, the value of the orientational order parameter $\Psi_3$ is 1 and the value of $R/\ell$ is 0. As the strain increases, the value of the orientation order parameter $\Psi_3$ shifts in the direction smaller than 1, and the value of $R/\ell$ shifts in the direction larger than 0. For example, when the average value of the orientation order parameter $\Psi_3$ is 1, 0.9, 0.8, 0.7, 0.6, and 0.5, it is evaluated that the degree of distortion of the diamond lattice structure is large in this order. When the average value of $R/\ell$ is 0, 0.05, 0.1, 0.15, 0.2 and 0.25, it is evaluated that the degree of distortion of the diamond lattice structure is large in this order. The present inventors have obtained a colloidal crystal having a diamond lattice structure with the average value of the orientation order parameter $\Psi_3$ of 0.6 or more and the average value of $R/\ell$ of 0.20 or less.

The colloidal crystal can have a two-dimensional diamond lattice structure which includes only one layer of each of the first layer, the second layer, and the third layer.

The first plurality of particles, the second plurality of particles, and the third plurality of particles can be all composed of particles having an average particle diameter of 50 to 1000 nm. When the particles have an average particle diameter of 1000 nm or less, the movement of the particles due to Brownian motion is hardly suppressed, and the particles are easily fitted into a stable arrangement. The average particle diameter can be obtained by averaging individual particle diameter measurement values according to a dynamic light scattering method or an electron microscope or an optical microscope. Since it is desirable that the particles forming the first layer, the second layer, and the third layer form a regular tetrahedral structure, the particles preferably have a similar size. Specifically, the coefficient of variation of the average particle diameter is preferably 20 % or less, more preferably 10 % or less.

In some aspects, the present invention provides a method for producing a colloidal crystal comprising:

a first layer forming step to form a single layer structure of a first charged colloidal crystal on a substrate by bringing the substrate having a surface charge opposed to a surface charge of a first plurality of charged colloid particles into contact with a first colloidal dispersion in which the first plurality of charged colloid particles are dispersed in a dispersion medium, the first colloidal dispersion being capable of precipitating a colloidal crystal and having a volume percent of the first plurality of charged colloidal particles of 15 to 19 %;

a second layer forming step to form a single layer structure of a second plurality of charged colloidal particles on the first layer by bringing the substrate having the first layer formed thereon into contact with a second colloidal dispersion comprising the second plurality of charged colloidal particles having a surface charge opposed to the surface charge of the first plurality of charged colloidal particles; and

a third layer forming step to form a single layer structure of a third plurality of charged colloidal particles on the second layer by bringing the substrate having the second layer formed thereon into contact with a third colloidal dispersion comprising the third plurality of charged colloidal particles having a surface charge opposed to the surface charge of the second plurality of charged colloidal particles.

Preferably, the first plurality of charged colloidal particles, the second plurality of charged colloidal particles, and the third plurality of charged colloidal particles all have a coefficient of variation of particle diameter of 20 % or less. This is because when the coefficient of variation of the particle diameter is 10 % or less, the particles are easily arranged regularly and a colloidal crystal structure having fewer defects is formed. The coefficient of variation (CV) of particle diameter refers to a value of (standard deviation of particle diameter $\times$ 100/average particle diameter) and is more preferably 10 % or less, further preferably 8 % or less, further preferably 7 % or less, further preferably 6 % or less, and most preferably about 5 % or less.

The first plurality of charged colloidal particles, the second plurality of charged colloidal particles, and the third plurality of charged colloidal particles can all have an average particle diameter of 50 nm to 1000 nm. When the particles are 1000 nm or less, the movement of the particles due to Brownian motion is hardly suppressed, and the particles are easily fitted into a stable arrangement.

The first layer forming step can include: a liquid layer forming step of forming a liquid layer made of a colloidal dispersion on the base material; and a single-layer structure growth step of diffusing a charge adjusting liquid capable of set of the surface charge of the base material opposite to that of the charge of the first plurality of colloidal particles from one end side of the liquid layer to grow a single layer structure of the colloidal crystal on the base material.

In this case, the base material can be made of a material having a surface charge changing depending on ion concentration, and the charge adjusting liquid can be an acid or a base capable of making the sign of the surface charge of the base material opposite to that of the charge of the first plurality of colloidal particles.

The liquid layer forming step may be performed by a step of preparing a charged colloidal dispersion in which the first plurality of colloidal particles are dispersed in a dispersion medium, a step of forming a liquid layer made of the charged colloidal dispersion on the base material, and a step of diffusing a colloidal crystallization preparation liquid capable of colloidal crystallization of the charged colloidal dispersion from one end side of the liquid layer. The "colloidal crystallization" refers to forming a colloidal crystal (the same applies hereinafter).

BRIEF DESCRIPTION OF THE DRAWINGS

FIG. 1 is a diagram showing a diamond lattice structure.
FIG. 2 is a diagram showing a face-centered cubic lattice structure, a body-centered cubic lattice structure, and a hexagonal close-packed lattice structure.
FIG. 3 is a schematic of a diamond lattice structure viewed in a direction perpendicular to a substrate.
FIG. 4 is a schematic showing a deviation R of a position of a particle in a third layer relative to a particle in a second layer of the diamond lattice structure.
FIG. 5 is a graph showing a relationship between a value of an orientational order parameter $\Psi_3$ and a position of a particle.
FIG. 6 is a process diagram showing a manufacturing process of a colloidal crystal having a diamond lattice structure according to a first embodiment.
FIG. 7 is plan and side views showing that the diamond lattice structure is formed by laminating one layer at a time.
FIG. 8 is perspective and plan views showing that the diamond lattice structure is formed by laminating one layer at a time.

FIG. 9 is a schematic showing a manufacturing process of a second embodiment.

FIG. 10 is a schematic cross-sectional view showing a method of diffusing a colloidal crystallization liquid 25 in a liquid layer 23 through a membrane filter 22 in a third liquid layer forming step S223 in the manufacturing process of the second embodiment.

FIG. 11 is a schematic showing a regular tetrahedron structure that is the smallest unit of the diamond lattice structure.

FIG. 12 shows graphs for $3U_{neg}$, $U_{tot}$, and $U_{pos}$ when the particle diameter is 510 nm.

FIG. 13 shows graphs for $3U_{neg}$, $U_{tot}$, and $U_{pos}$ when the particle diameter is 51 nm.

FIG. 14 is a graph showing a calculation result of Yukawa-type electrostatic potential formed on a plane of a second layer by charged colloidal particles having a particle radius a arranged on lattice points.

FIG. 15 is a photograph of a colloidal crystal forming a diamond lattice structure prepared in Example 1 taken by an inverted optical microscope.

FIG. 16 is a photograph of a colloidal crystal forming a diamond lattice structure prepared in Example 2 taken by an inverted optical microscope.

FIG. 17 is a photograph of a colloidal crystal forming a diamond lattice structure prepared in Example 3 taken by an inverted optical microscope.

FIG. 18 is a distribution chart when R and $\ell$ are obtained from observation with an inverted microscope and a $\Psi_3$ value is calculated from those values.

FIG. 19 is a graph showing a distribution of a value $R/\ell$ normalized by a length (1) of one side of a triangle formed in the first layer (the graph on the left shows a result when the average value of $\Psi_3$ is 0.647, the graph on the center shows a result of counting only when $\Psi_3>0.8$ is satisfied, and the graph on the center shows a result of counting only when $\Psi_3>0.8$ is satisfied).

FIG. 20 is a confocal laser scanning microscope image of a three-layer structure composed of polystyrene particles.

FIG. 21 is a confocal laser scanning microscope image having a three-layer structure composed of titanium oxide particles.

## DETAILED DESCRIPTION OF THE PREFERRED EMBODIMENTS

(First Embodiment)

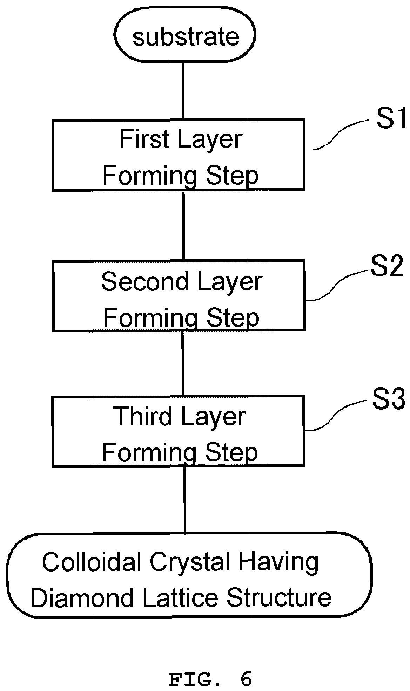

FIG. 6 illustrates a process diagram showing a manufacturing process of a colloidal crystal having a diamond lattice structure according to a first embodiment. The description that follows will be made with reference to this process diagram.

<First Layer Forming Step S1>

First, a first charged colloidal dispersion is prepared. A volume percent of first charged colloidal particles in the first charged colloidal dispersion is 17±2 % (i.e., 15 % to 19 %). The type of the colloidal particles dispersed in the dispersion is not limited, and examples thereof include particles made of an inorganic substance such as silica, alumina, and a silicate compound, and particles made of an organic substance such as polystyrene, polyethylene, and acrylic resin. These colloidal particles are dispersed as charged colloidal particles having a positive or negative surface charge, the charged colloidal particles repel each other by the Coulomb force, and the charged colloidal particles are allowed to stand still so that colloidal crystals are formed with the particles separated at a certain distance due to the Coulomb force. To adjust the surface charge of the charged colloid, an electrolyte such as an acid, a base, or a salt may be added, or the surfaces of the colloidal particles may be chemically modified with various surface treatment agents.

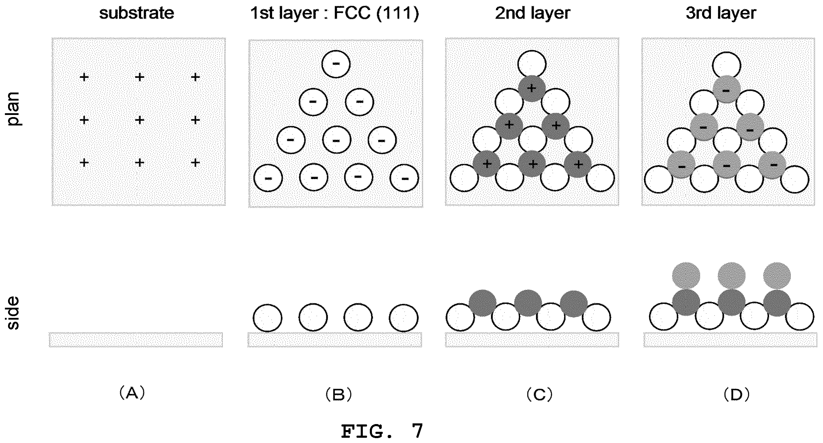

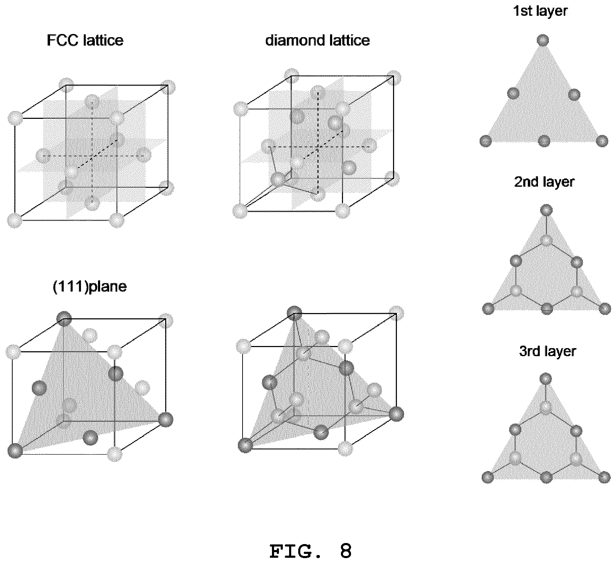

A substrate having a surface charge with a sign opposite to the surface charge of the first charged colloid particles is then prepared (see FIG. 7A), and the substrate is immersed in the first charged colloidal dispersion so that the first charged colloidal particles are adsorbed on the surface of the substrate (see FIGs. 7(B) and 8). Since the first charged colloidal dispersion is capable of precipitating colloidal crystals, the first charged colloidal particles are regularly aligned in the dispersion. The distance between the centers of the closest charged colloidal particles is calculated to be 1.6 times the particle diameter from the geometrical consideration of the regular tetrahedral structure. In the (111) plane of the face-centered cubic lattice (hereinafter referred to as fcc), when the interparticle distance is 1.6 times the particle diameter, the volume percent of the colloidal particles is calculated to be about 17 %. By electrostatically adsorbing a colloidal dispersion of this concentration to the substrate, a first layer meeting the requirements for forming a regular tetrahedral structure with a diamond lattice structure on the fcc (111) plane on the substrate is formed (see FIGs. 7(B) and 8). If the volume percent of the first charged colloidal particles has an error within 17±2 %, although some disturbance occurs when the second layer is laminated, the first layer can be formed on the fcc (111) plane. However, when the volume percent of the first charged colloidal particles exceeds the range of 17±2 % (i.e., the range of 15 % or more and 19 % or less), although the layer is formed on the fcc (111) plane on the substrate, a disturbance of several percent is generated when the particles of the second layer are laminated, and this is not suitable for the first layer of the diamond structure.

As the base material, for example, a glass substrate, a ceramic substrate, a silicon substrate, etc. can be used. These base materials usually have a negative surface potential due to the silanol group; however, the surface potential can be made positive by modification with the amino group using a silane coupling agent such as aminopropyltriethoxysilane or by adsorption of a polymer having a cationic group such as polyethyleneimine or poly(2-vinylpyridine) on the surface.

<Second Layer Forming Step S2>

The substrate having the first layer formed thereon is brought into contact with a second colloidal dispersion composed of second charged colloidal particles having a surface charge with a sign opposite to the surface charge of the first charged colloidal particles so as to form a second layer having a single layer structure composed of the second charged colloidal particles on the first layer. The charged colloidal particles in the second layer are each accommodated in contact with and at the center of the three adjacent charged colloidal particles in the first layer (see FIGs. 7(C) and 8). In addition to the electrostatic attraction, other attraction interactions such as the depletion attraction generated by addition of polymer [Henk N.W. Lekkerkerker and R. Tuiner, Colloids and the Depletion Interaction, Springer, 2011] can also be used together. When salts, acids, and bases are used at the time of formation of the second layer, these can be removed by washing with water or ion exchange after the second layer is formed.

<Third Layer Forming Step S3>

Finally, the substrate having the second layer formed thereon is brought into contact with a third colloidal dispersion composed of third charged colloidal particles having a surface charge with a sign opposite to the surface charge of the second charged colloidal particles so as to form a third layer having a single layer structure composed of the third charged colloidal particles on the second layer (see FIGs. 7(D) and 8). The charged colloidal particles in the third layer are accommodated in contact with and directly above the charged colloidal particles in the second layer (see FIGs. 7(D) and 8). In this way, a colloidal crystal having a diamond lattice structure is obtained that includes a first layer in which first particles are arranged on the (111) plane of the face-centered cubic lattice structure, a second layer in which second particles are arranged on the first layer in contact with the first particles, and a third layer in which third particles are arranged on the second layer in contact with the second particles (see FIGs. 7D and 8).

In a method for producing the colloidal crystal according to the first embodiment, since the charged colloidal particles self-assemble to form the diamond lattice structure, the colloidal crystal can easily be produced without the need for using a complicated pattern forming technique such as processing by electron beam lithography or precise drilling. Additionally, a two-dimensional diamond lattice structure can also be produced by sequentially performing the first layer forming step S1, the second layer forming step S2, and the third layer forming step S3 once each. Furthermore, since colloidal particles are used, a conventionally unknown diamond lattice structure composed of particles having a size of 50 nm or more can be produced. Therefore, this is suitable as a photonic crystal.

Repeating the first layer forming step S1, the second layer forming step S2, and the third layer forming step S3 multiple times can provide a colloidal crystal having a three-dimensional diamond lattice structure in which the first layer, the second layer and the third layer are repeated multiple times.

(Second Embodiment)

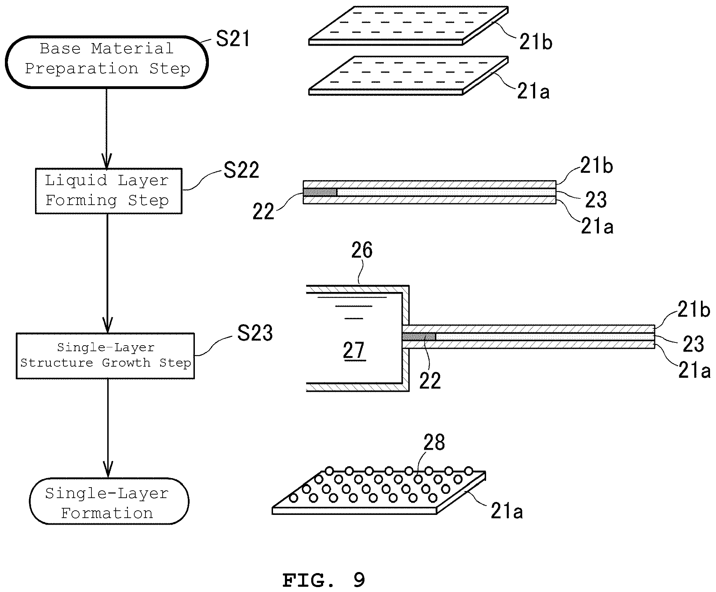

In a method according to this second embodiment, when the first layer forming step S1 is performed, a liquid layer made of the first colloidal dispersion is formed on the substrate, and a charge adjusting liquid is diffused from one end side of the liquid layer to grow a single-layer structure of colloidal crystals (i.e., two-dimensional charged colloidal crystals). FIG. 9 illustrates a process diagram showing a manufacturing process of the colloidal crystals. The description that follows will be made with reference to FIG. 9.

<Base Material Preparation Step S21>

For base materials, two base materials 21a and 21b formed from glass substrates, ceramic substrates, or silicon substrates are prepared and faced each other in parallel while maintaining a certain distance through a spacer not shown, and a membrane filter 22 is further inserted on one end side of the base material 21a and the base material 21b.

<Liquid Layer Forming Step S22>

In a liquid layer forming step S22, a liquid layer 23 made of the first colloidal dispersion is formed. The following two general methods exemplify this process.

(Method 1)

In a first general method, the first charged colloidal dispersion used in the first embodiment is prepared. The volume percent of the first charged colloid particles in the first charged colloidal dispersion needs to be 17±2 % (i.e., 15 % or more and 19 % or less). The charged colloidal crystal dispersion is filled into a gap between the two base materials 21a, 21b. In this way, the liquid layer 23 made of the first colloidal dispersion is formed in the gap between the two base materials 21a, 21b.

(Method 2)

In a second general method, the liquid layer forming step S22 of Method 2 comprises the following three steps.

- First Liquid Layer Forming Step S221

A colloidal dispersion of colloidal particles having a positive (or negative) charge dispersed in a solvent is prepared (in this dispersion, the colloidal particles are not colloidally crystallized).

- Second Liquid Layer Forming Step S222

The colloidal dispersion is then filled into the gap between the two base materials 21a, 21b.

- Third Liquid Layer Forming Step S223

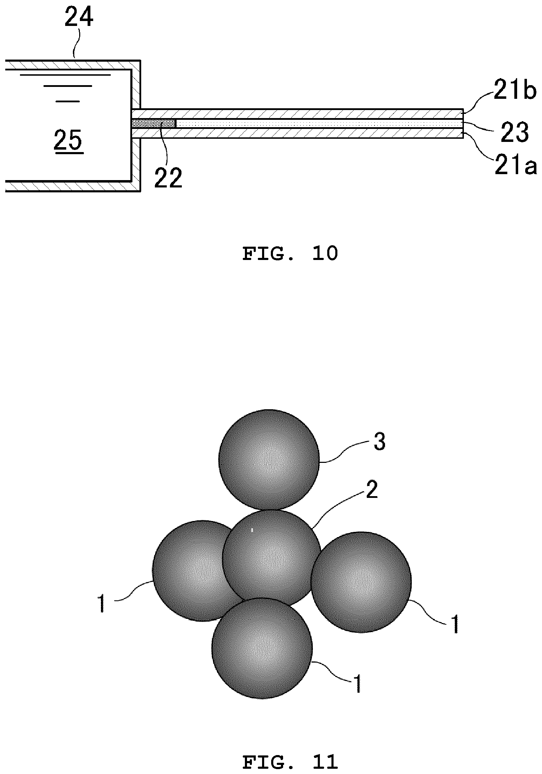

As shown in FIG. 10, the membrane filter 22 side is then connected to a reservoir tank 24. Since the colloidal crystallization liquid 25 capable of colloidal crystallization of the colloidal dispersion is stored in the reservoir tank 24, the colloidal crystallization liquid diffuses in the liquid layer 23 through the membrane filter 22. Therefore, the colloidal dispersion in the liquid layer 23 colloidally crystallizes from the membrane filter 22 side toward the other end side. As the colloidal crystallization liquid 25, for example, pure water can be used. In this case, ions in the colloidal dispersion 23 pass through the membrane filter 22 and diffuse into the pure water in the reservoir tank 24. Therefore, the ion concentration in the colloidal dispersion 23 is diluted from the membrane filter 22 side toward the other end side, and the ionic strength is lowered. Therefore, the repulsive force between the colloidal particles gradually increases, and the colloidal crystals grow from the membrane filter 22 side toward the other end side.

<Single-Layer Structure Growth Step S23>

Subsequently, as shown in FIG. 9, the membrane filter 22 side of the base materials 21a, 21b facing each other in parallel is connected to the reservoir tank 26. The reservoir tank 26 stores a charge adjusting liquid 27 capable of making the sing of the surface charge of the base material opposite to the sign of the charge of the colloidal particles, and the charge adjusting liquid 27 diffuses in the liquid layer 23 through the membrane filter 22. Therefore, the colloidal particles in the liquid layer 23 are gradually adsorbed onto the base materials 21a, 21b by electrostatic attraction from the membrane filter 22 side for one layer of the charged colloidal crystals. As a result, two-dimensional charged colloidal crystals 28 arranged at predetermined lattice intervals are formed. The charge adjusting liquid 27 may be selected in accordance with the type of the base materials and, for example, an acid such as hydrochloric acid, sulfuric acid, nitric acid, or acetic acid, or a base such as sodium hydroxide, potassium hydroxide, sodium carbonate, or aqueous ammonia can be used.

Since the two-dimensional charged colloidal crystals 28 formed in this way gradually grow due to diffusion, the two-dimensional colloidal crystals with fewer defects are formed. Since the volume percent of the first charged colloidal particles are set to a value close to 17 %, the interparticle distance of the charged colloidal particles has a value close to 1.6 times the particle diameter, and the first layer for forming the regular tetrahedron structure of the diamond lattice structure on the base material 21a is formed (see FIGs. 7(B) and 8).

In this way, the second layer forming step S2 and the third layer forming step S3 same as those of the first embodiment are sequentially performed on the base materials 21a, 21b on which the first layer is formed, which provides colloidal crystals having a diamond lattice structure including the first layer in which the first particles are arranged on the (111) plane of the face-centered cubic lattice structure, the second layer in which the second particles are arranged in contact with the first particles on the first layer, and the third layer in which the third particles are arranged in contact with the second particles on the second layer (see FIGs. 7(D) and 8).

In the method for producing the colloidal crystal according to the second embodiment, the colloidal crystals having a larger and less defective two-dimensional diamond lattice structure can be formed by gradually growing the colloidal crystals by utilizing the diffusion phenomenon.

Repeating the steps of the second embodiment multiple times can provide a colloidal crystal having a three-dimensional diamond lattice structure in which the first layer, the second layer, and the third layer are repeated multiple times.

<Mechanism of Formation of a Three-Dimensional Diamond Lattice Structure>

- Theoretical Calculation of Interaction Potential between Particles

Although the mechanism of formation of the three-dimensional diamond lattice structure according to the present invention is not completely clarified, the mechanism can be presumed by applying the equation of the interaction potential (Yukawa potential) between the charged particles 1 and 2 (see Equation 3 below) to the interaction potential between particles in the regular tetrahedron structure (see FIG. 11) that is the smallest unit of the diamond lattice structure.
[Math. 2]

$$U_Y(r) = \frac{\exp[\kappa(a_1 + a_2)]}{(1 + \kappa a_1)(1 + \kappa a_2)} \frac{1}{4\pi\varepsilon_r\varepsilon_0} \frac{Z_1 Z_2 e_0^2}{r} \exp(-\kappa r) \quad \cdots (3)$$

where

  $\kappa$: Debye Parameter, $\kappa^2$ is proportional to Salt Concentration;
  $a_1$ and $a_2$: Radiuses of particles 1 and 2, respectively;
  $Z_1$ and $Z_2$: Numbers of charges of particles 1 and 2, respectively;
  $\varepsilon_0$ and $\varepsilon_r$: Vacuum permittivity and Relative permittivity of medium, respectively;
  $e_0$: Elementary electric charge; and
  r: Distance between centers of particles.

In the regular tetrahedron structure that is the smallest unit of the diamond lattice structure shown in FIG. 10, the particle 2 is arranged in the central portion of the three particles 1, and the particle 3 is arranged directly above the particle 2. For the particle 3 to be electrostatically adsorbed directly above the particle 2, it is necessary that the particles 1 and 3 are negatively charged and the particle 2 is positively charged. Whether the particle 3 is electrostatically adsorbed is determined by the balance of the electrostatic repulsive force ($U_{neg}$) between the particles 1 and the particle 3 and the electrostatic attractive force ($U_{pos}$) between the particle 2 and the particle 3 in this case.
Specifically, this is represented by the following equations.

  Adsorption is not achieved when total energy $U_{tot}=U_{neg}+U_{pos}>0$.
  Adsorption is achieved when total energy $U_{tot}=U_{neg}+U_{pos}<0$.

However, since desorption occurs due to thermal motion in the case of $U_{tot}<k_BT$, the condition of $U_{tot}>k_BT$ is required.
When the electrostatic repulsive force ($U_{neg}$) between the particles 1 and the particle 3 is sufficiently larger than the thermal energy $k_BT$ ($3U_{neg}> -k_BT$ since the three particles 1 exist), the particle 3 is strongly repelled by the three particles 1 and placed directly above the particle 2 to form the regular tetrahedron structure that is the smallest unit of the diamond lattice structure.
From the above consideration, $U_{tot}<k_BT$ and $3U_{neg}> -k_BT$ are conditions for the particle 2 to be arranged in the central portion of the three particles 1 and the particle 2 to be arranged directly above the particle 2 in the regular tetrahedron structure that is the smallest unit of the diamond lattice structure. However, these conditions are calculated values for the case of one regular tetrahedron structure that is the smallest unit of the diamond lattice structure and does not apply to the case of the three-dimensional diamond lattice structure. Additionally, in the case of the two-dimensional diamond lattice structure, to be exact, consideration must be given to the electrostatic force from the particles existing around the regular tetrahedron structure of interest; however, the particles existing therearound are far away, and therefore, the impact thereof is presumed to be small.

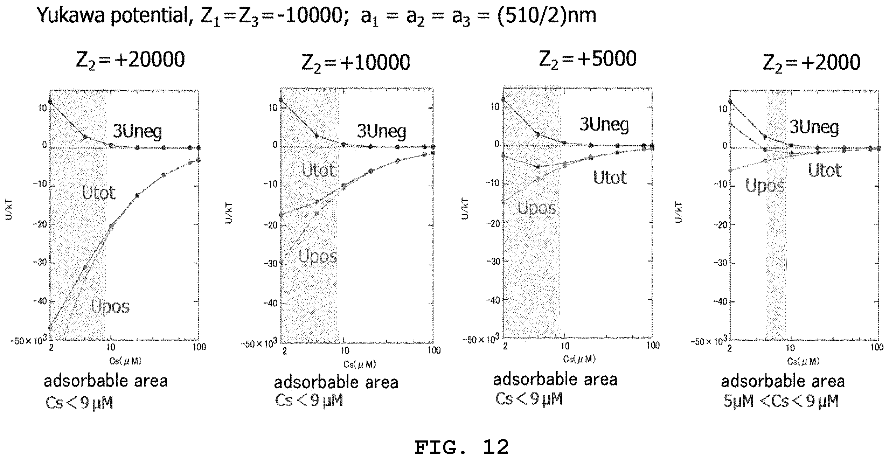

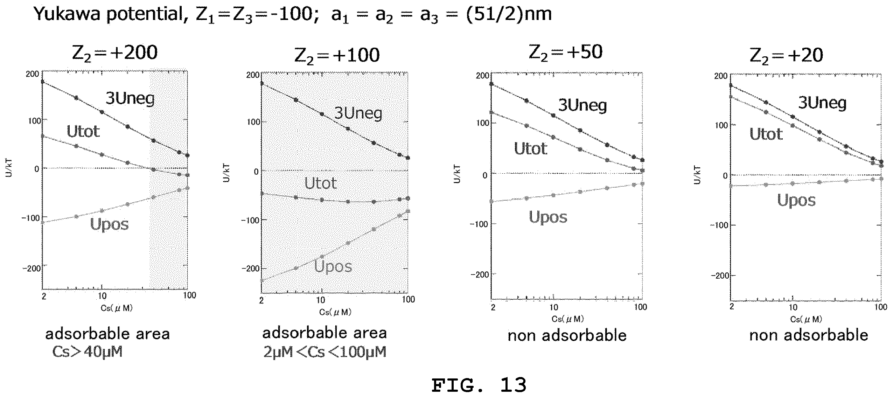

FIG. 12 shows graphs for $3U_{neg}$, $U_{tot}$, and $U_{pos}$ when the particle diameter is 510 nm. FIG. 13 shows graphs for $3U_{neg}$, $U_{tot}$, and $U_{pos}$ when the particle diameter is 51 nm. From these graphs, it was found that when the particle diameter is smaller, the diamond lattice structure can be formed at a higher salt concentration.

- Theoretical Calculation of Effect of Salt Concentration on Particle Arrangement of Second Layer

When the diamond lattice structure is constructed by laminating particles, a particle in the second layer needs to be placed in the center of the regular triangular structure of the FCC (111) lattice formed by particles in the first layer. On the other hand, a particle in the third layer needs to be located directly above the particle in the second layer.

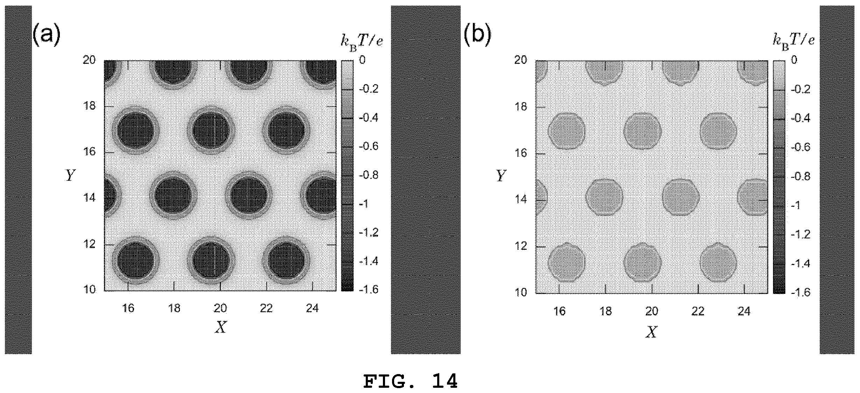

The Yukawa-type electrostatic potential created by the charged colloidal particles having the particle radius a arranged on the lattice points on the plane of the second layer was calculated. An example of the result is shown in FIG. 14. $Z_1=-10000$ is set, and (a) and (b) show the results of the shielding parameter $\kappa_{a1}=\kappa_{a2}=8.3$ and 57.7, respectively. The scale of space (X, Y) was the particle radius a=500nm, and for the scale of electrostatic potential, $k_BT/e=2.6\times10^{-2}$J/C was used as a unit ($k_BT$ denotes thermal energy, e denotes elementary electric charge). The effect of charge on the substrate is not considered. When the plane of the second layer is inside the particles of the first layer, the same value as the potential of the particle surface is displayed. High-energy spots exist in both (a) and (b), which coincide with the coordinates of the particles in the first layer, indicating that the most stable arrangement is directly above the particles in the lower layer. The center of the equilateral triangle is the position of "unstable balance", and if a particle is located exactly in the center, the attractive force from the surrounding three particles will be balanced; however, if the position deviates even slightly, the position will not be restored and a shift to stable arrangement will occur over time. The position directly above the lower layer is the most stable in both (a) and (b), and this does not depend on the salt concentration. On the other hand, the steric stable arrangement is the center of the three particles forming an equilateral triangle, and when the salt concentration is sufficiently high and the interaction energy is sufficiently smaller than $k_BT$, the particle should be located in the center. From the above results, it can be seen that when the second layer is formed by adsorption from the colloidal dispersion, a strain of the diamond lattice structure can be controlled by controlling the salt concentration of the colloidal dispersion.

Examples of the present invention will now be described.

(Example 1)

<Preparation of Base Material>

After a cover glass for an optical microscope (manufactured by Matsunami Glass Ind., Ltd.) was immersed in concentrated sulfuric acid for 24 hours and was turned over and immersed for another 24 hours, the cover glass was washed with water, further washed with ethanol, and then dried for 2 hours in a constant temperature bath kept at 65 °C to form a glass substrate.

<Modification on Surface of Base Material>

Subsequently, a toluene solution (0.1 %) of 3-aminopropyltriethoxysilane (APTES) was placed in a glass petri dish, and the glass substrate was immersed. After 2 hours, the glass substrate was removed, ultrasonically washed in toluene, a 1:1 toluene/methanol solution, and methanol for 3 minutes each, and then dried at 65 °C for 16 hours. By modifying the silanol group of the glass substrate with 3-aminopropyltriethoxysilane (APTES), an APTES-modified glass substrate with a positive charge introduced into the surface by the amino group was obtained.

Subsequently, a plastic 8-cell frame (the size of each cell is 1 cm square) was attached to this APTES-modified glass substrate with an adhesive to create a cell for microscopic observation. After washing the cell with Milli-Q water several times, a 0.1 mol/L NaOH aqueous solution was put into each section of the cell and kept at room temperature for 45 minutes to hydrolyze and remove the excess remaining APTES, and the cell was then sufficiently washed with Milli-Q water and dried at room temperature.

<First Colloidal Dispersion Preparation Step>

Subsequently, for a first colloidal dispersion preparation step, to a dispersion purified by dialyzing silica particles having a negative surface charge (KE-P50 manufactured by Nippon Shokubai Co., Ltd., having an average particle diameter of 513 nm, a coefficient of variation of particle diameter of 4 %, and a zeta potential of -58 mV) with Milli-Q water, NaOH was added to a concentration of 200 μM to obtain a silica dispersion adjusted to contain 17 vol.% of the silica particles. The average particle diameter was obtained by measuring and averaging 50 or more particle diameters from a SEM image of a scanning electron microscope (each particle was almost a perfect circle) (the same applies hereinafter).

<First Layer Forming Step>

Subsequently, 100 μL of the silica dispersion prepared in the first colloidal dispersion preparation step was added dropwise to the APTES-modified substrate. Since NaOH is added to the silica dispersion, the silanol group of the glass surface is dissociated to increase an amount of negative charge.

To this silica dispersion, 10 to 20 pieces of ion exchange resin (mix-bed type ion exchange resin manufactured by BioRad) were added and allowed to stand overnight. This operation removes NaOH in the silica dispersion by ion exchange to return the dissociated silanol group of the glass surface to the undissociated silanol group, and the amino group present in the APTES-modified substrate make the surface potential positive so that the silica particles having a negative surface charge are adsorbed to form the first layer. The APTES-modified substrate with the first layer formed in this way was washed with Milli-Q water and stored in a state where water was added.

<Second Layer Forming Step>

To 100 μL of 400 μM cetylpyridinium chloride (CPC) aqueous solution, 900 μL of 1 vol.% dispersion of red fluorescent polystyrene particles manufactured by Thermo Fisher Scientific and having an average particle diameter of 545 nm measured by observation with a scanning electron microscope and a coefficient of variation of particle diameter of 2 % was added little by little to prepare a polystyrene particle dispersion having a CPC concentration of 40 μM. The red fluorescent polystyrene particles are in a state of having a positive surface charge due to the adsorption of CPC.

Milli-Q water in the cell of the APTES-modified substrate having the first layer of silica particles formed thereon was discarded, and 100 μL of the polystyrene particle dispersion described above was immediately dropped. After allowing to stand for 30 minutes, the cell was washed with a 40 μM CPC aqueous solution to remove excess particles, and finally washed with a 10 μM CPC aqueous solution. In this way, a second layer composed of the red fluorescent polystyrene particles having a positive surface charge was formed on the first layer composed of the silica particles having a negative surface charge.

<Third Layer Forming Step>

Finally, the Milli-Q water in the cell of the APTES-modified substrate having the second layer formed on the first layer is discarded, and 100 μL of a 0.25 volume % dispersion of polystyrene particles having a negative surface charge (manufactured by Thermo Fisher Scientific and having an average particle diameter of 514 nm measured by observation with a scanning electron microscope, a coefficient of variation of particle diameter of 2 %, and green fluorescence) was dropped and allowed to stand for 60 minutes. The cell was washed with a 10 μM CPC aqueous solution to remove excess particles. In this way, the third layer composed of the green fluorescent polystyrene particles having a negative surface charge was formed on the second layer composed of the red fluorescent polystyrene particles having a positive surface charge.

- Evaluation -

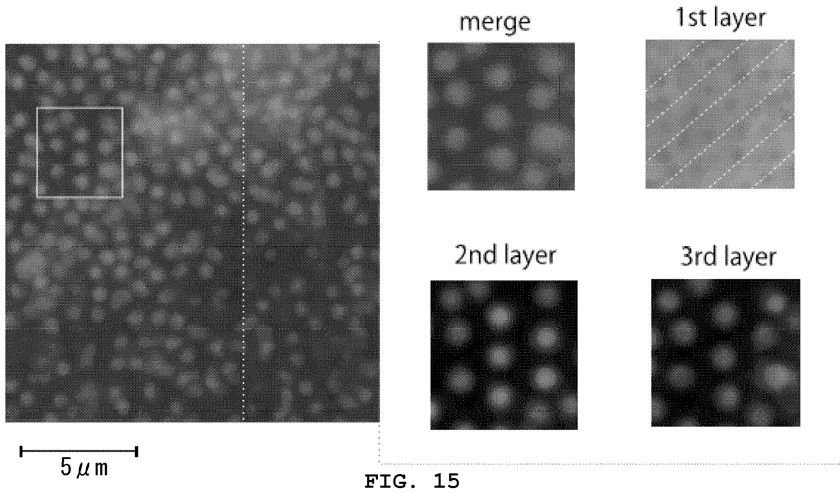

With an inverted optical microscope, the structures of the first layer after the first layer forming step, the second layer after the second layer forming step, and the third layer after the third layer forming step were observed. As a result, as shown in FIG. 15 (see a superimposed image (merge) and an image of each of the first layer, the second layer, and the third layer), colloidal crystals forming a diamond lattice structure were observed.

(Example 2)

In Example 2, in the modification of the substrate surface with APTES in Example 1, a time of hydrolyzing and removing the excess remaining APTES by putting the 0.1 mol/L NaOH aqueous solution into each section of the cell was set to 30 minutes. Additionally, the concentration of polystyrene particles at the time of adsorption of polystyrene particles in the second layer forming step was set to 5 μL of a 10 vol.% dispersion, and after about 10 seconds, the cell was immediately washed with Milli-Q water. After adsorbing the polystyrene particles in this way, washing with a 10 μM CPC aqueous solution was not performed. The other conditions are the same as the first embodiment and will not be described.

- Evaluation -

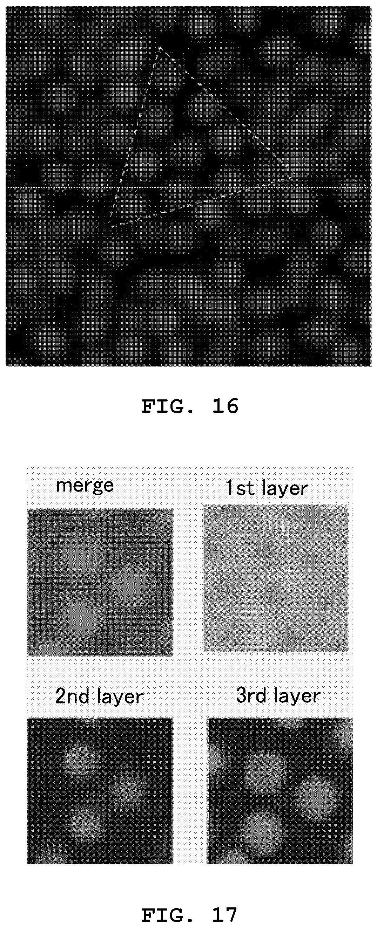

The structure seen from the surface was observed with an inverted optical microscope. As a result, as shown in FIG. 16, colloidal crystals forming a diamond lattice structure were observed.

(Example 3)

In Example 3, for the first layer, silica particles having a negative surface charge (KE-P100 manufactured by Nippon Shokubai Co., Ltd., having an average particle diameter of 1000 nm measured by observation with a scanning electron microscope, a coefficient of variation of particle diameter of 4 %, and a zeta potential of -44 mV) were used. For the second layer, polystyrene particles having a positive surface charge (synthesized in the laboratory, having an average particle diameter of 810 nm, a coefficient of variation of particle diameter of 4 %, and a zeta potential of +46 mV) were used. For the third layer, polystyrene particles having a negative surface charge (G100B manufactured by Thermo, having an average particle diameter of 1025 nm, a coefficient of variation of particle diameter of 2 %, and a zeta potential of -50 mV) were used. The particles in the second layer were dyed with a red fluorescent dye, and the particles in the third layer were dyed with a green fluorescent dye. In the modification of the substrate surface with APTES in Example 1, a time of hydrolyzing and removing the excess remaining APTES by putting the 0.1 mol/L NaOH aqueous solution into each section of the cell was set to 45 minutes. Since the polystyrene particles in the second layer forming step were positively charged, CPC was not added. The other conditions are the same as the first embodiment and will not be described.

- Evaluation -

The structure of the two-dimensional colloidal crystals prepared in Example 3 was observed from the surface with an inverted optical microscope. As a result, as shown in FIG. 17, colloidal crystals forming a diamond lattice structure were observed (see a superimposed image (merge) and an image of each of the first layer, the second layer, and the third layer).

(Example 4)

<Analysis of the Relationship between diamond lattice structure and salinity>

From results of the theoretical calculation of interaction potential between particles, it was presumed that the salt concentration had no effect on the lamination of the first layer, whereas the salt concentration had an effect on the lamination of the second layer. Therefore, the effect of salt concentration on the lamination of the second layer was experimentally studied.

By using silica particles (diameter d=1000 nm, zeta potential $\zeta$=-44 mV, non-fluorescent) for the first layer and polystyrene particles (d=809 nm, $\zeta$=+ 34 mV, red fluorescence) for the second layer, the first layer and the second layer of the diamond lattice structure were formed by the same method as Example 1. The coordinates of the particles of the first layer and the second layer were obtained from observation with an inverted optical microscope, and regularity was evaluated as follows. FIG. 3 shows a lamination structure viewed in a direction perpendicular to a substrate, and the particle size is drawn smaller than the actual size for easy viewing (actually, the particles in the first layer and the second layer are in contact with each other). In the figure, $b_n$ is a vector (bond vector) from the center of the particle in the second layer to the centers of the three particles in the first layer. The arrangement of the particle in the second layer can be evaluated by using an orientation order parameter $\Psi_3$ defined by Equation (4) below. In the case of a perfect diamond lattice structure, $\Psi_3$ becomes 1, and $\Psi_3$ has a smaller value as the particle arrangement deviates from the perfect diamond lattice structure.

[Math. 3]

$$\psi_3 = \frac{1}{3}\sum_{n=1}^{3}\left|e^{-3i\theta_n}\right| \qquad \cdots (4)$$

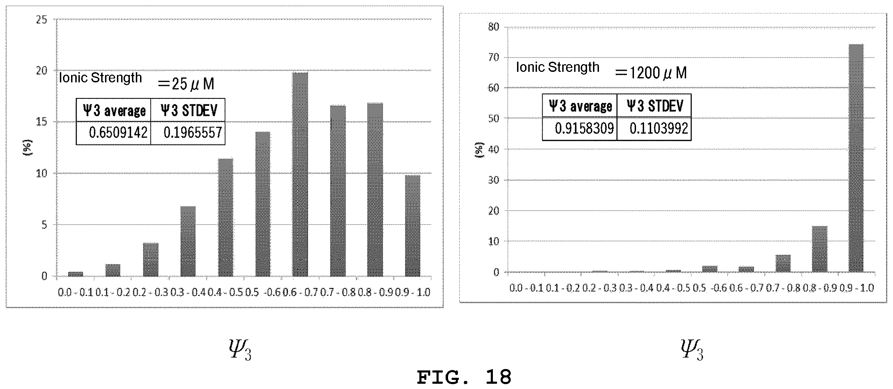

An angle denoted by $\theta_n$ is an angle formed by $b_n$ and a reference axis (arbitrarily definable and defined as the x-axis in FIG. 3). When the particle in the second layer is always located at the center of the equilateral triangle formed by the first layer particles, $\Psi_3$ has a maximum value of 1, and when no correlation with the second layer exists, $\Psi_3$ has a minimum value of 0. R and $\ell$ were obtained by observation with an inverted microscope and $\Psi_3$ was calculated therefrom to acquire a distribution chart shown in FIG. 18. The left and right sides show distributions of $\Psi_3$ value at ionic

strength I=25 $\mu$M and I=1200 $\mu$M, respectively. The average values of $\Psi_3$ were 0.651 and 0.916, respectively, and the standard deviations of the distribution were 0.17 and 0.11. It was clearly shown that when the salt concentration is lower, $\Psi_3$ is larger, i.e., the second layer particle is located closer to the center of the first layer triangle.

- Effect of Salt Concentration on Particle Arrangement of Third Layer

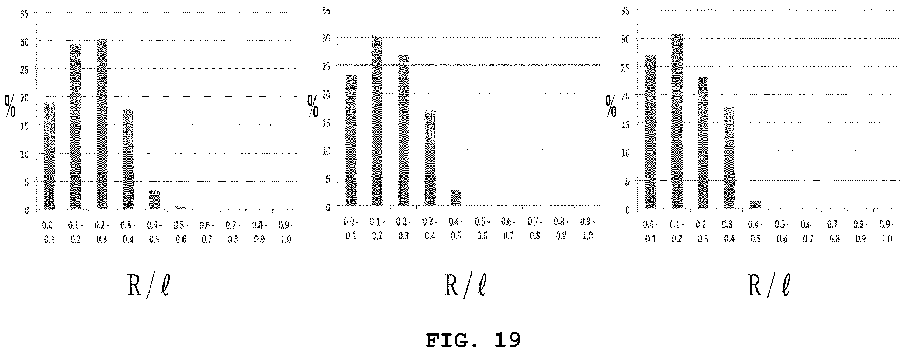

The third layer was further formed as in Example 1. Polystyrene particles (d=1025 nm, $\zeta$=-50 mV, green fluorescence) were used as the particles in the third layer. As a result of observation with an inverted optical microscope, it was found that the particles in the third layer of the diamond lattice structure are located almost directly above the particles in the second layer. The particle arrangement was evaluated by using a deviation (R) of a position of a third layer particle relative to a second layer particle. The result is shown in a graph on the left side of FIG. 19. The average value of $\Psi_3$ in the second layer in this case was 0.647, and the standard deviation of distribution was 0.254 (the number of particles in the third layer measured was 393). When the value of $\Psi_3$ is closer to 1, the particle arrangement of the second layer is closer to a regular tetrahedron. Graphs in the center and on the right side of FIG. 19 show results of counting only when the first layer and the second layer satisfy $\Psi_3$>0.8 and $\Psi_3$>0.9, respectively. The number of particles of interest was 142 and 78, respectively. The average values of R/$\ell$ were 0.190 and 0.180, and the standard deviations of the distribution were 0.108 and 0.107. As described above, it was found that when the value of $\Psi_3$ is closer to 1, R/$\ell$ decreases and becomes closer to a regular tetrahedron.

(Example 5)

<Preparation of Large Area Diamond Lattice Structure>

An attempt was made to increase the area of the diamond lattice structure by adjusting the salt concentration of the charged colloidal dispersion.

After a plastic 8-cell frame was attached to the APTES-modified glass substrate with an adhesive and the cell was washed with Milli-Q water several times, 30 $\mu$L of a 10 mM sodium hydroxide aqueous solution was put into each section of the cell, and an ion exchange resin and a colloidal dispersion for preparing the first layer were added. The colloidal particles in the second layer were adsorbed by adding a 10 mM aqueous sodium chloride solution. The colloidal particles in the third layer were adsorbed under the condition that the salt content was removed as much as possible after the colloidal dispersion used at the time of absorption of the second layer was sufficiently washed with purified water to sufficiently remove sodium chloride. The colloidal particles are all polyethylene particles; the first layer was formed by using the polyethylene particles having the diameter d=1001 nm and the zeta potential $\zeta$=-70 mV and colored for green fluorescence; the second layer was formed by using the polyethylene particles having the diameter d=1150 nm and the zeta potential $\zeta$=+51.4 mV without fluorescence; and the third layer was formed by using the polyethylene particles having the diameter d=1036 nm and the zeta potential $\zeta$=-68 mV and colored for red fluorescence. Other conditions are the same as the first embodiment and will not be described.

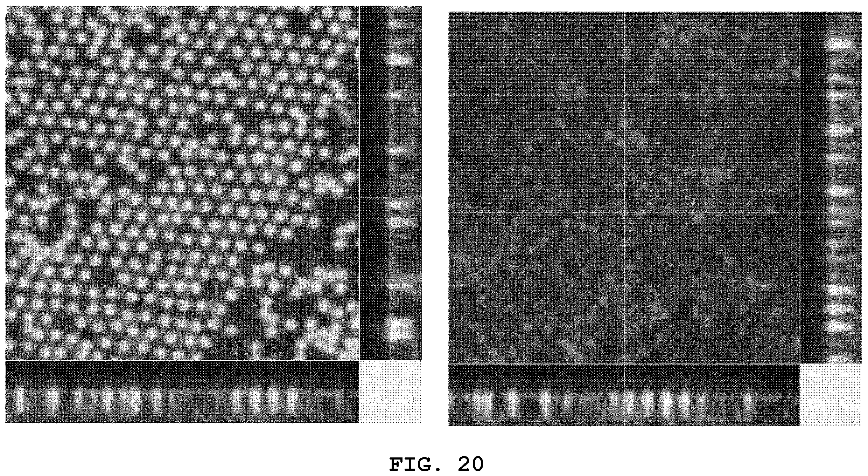

The three-layer diamond lattice structure obtained in this way was observed with a confocal laser scanning microscope. The results are shown in FIG. 20. A left photograph was taken with the focal plane set between the first layer particles and the second layer particles (the second layer particles are observed as white spots between green particles). A right photograph is a result of photographing with the focal plane set at the height of the third layer particles, and the crystal structure of the third layer particles looking red is observed. The lower and right sides of the screen show a luminance profile in the Z direction (i.e., when the focal plane is changed in the depth direction) when the three-dimensional image is cut at a position of a straight line shown in the image. These photographs confirmed that the diamond lattice structure was formed.

(Example 6)

<Preparation of Single-Layer Diamond Lattice Structure of Titania Particles>

The creation of a diamond crystal structure using titania (titanium dioxide $TiO_2$) particles as high-refractive index particles useful for application to optical elements was studied. To form a complete photonic band, the refractive index of the particles needs to be about 2 or more, and the refractive index of the titania particles is about 2.5, which satisfies this condition.

- Preparation of negatively Charged Titanium Oxide Particles by Chemical Modification

Titanium isopropoxide was hydrolyzed into titania particles by a sol-gel method, purified by dialysis, and then fired at 400°C. The surfaces of the titania particles obtained in this way were modified with tetraethoxysilane, and the surfaces thereof were then further modified with 3-methacryloxypropyltriethoxysilane to introduce a vinyl group. Styrene sulfonic acid was copolymerized with the vinyl group introduced in this manner to introduce the sulfonic acid group to the surfaces of the particles so as to obtain a colloidal dispersion in which the negatively charged titanium particles were dispersed. The average particle diameter obtained by SEM observation was 793 nm±31.9 nm, the zeta potential was $\zeta$=-45.36 mV, and the particle concentration $C_p$ was 0.233 vol.%. This colloidal dispersion was used to prepare the first and third layers.

- Preparation of Positively Charged Titanium Oxide Particles by Chemical Modification

Titanium isopropoxide was hydrolyzed into titania particles by a sol-gel method, purified by dialysis, and then fired at 400°C. The surfaces of the titania particles obtained in this way were chemically modified with trimethoxysilylpropylated polyethyleneimine to introduce a positive charge to obtain a colloidal dispersion in which positively charged titanium oxide particles were dispersed. The average particle diameter obtained by SEM observation was 859 nm±34.2 nm, the zeta potential was $\zeta$=+25.31 mV, and $C_p$ was 0.209 vol.%. This colloidal dispersion was used to prepare the second layer.

- Preparation of Single-Layer Diamond Lattice Structure

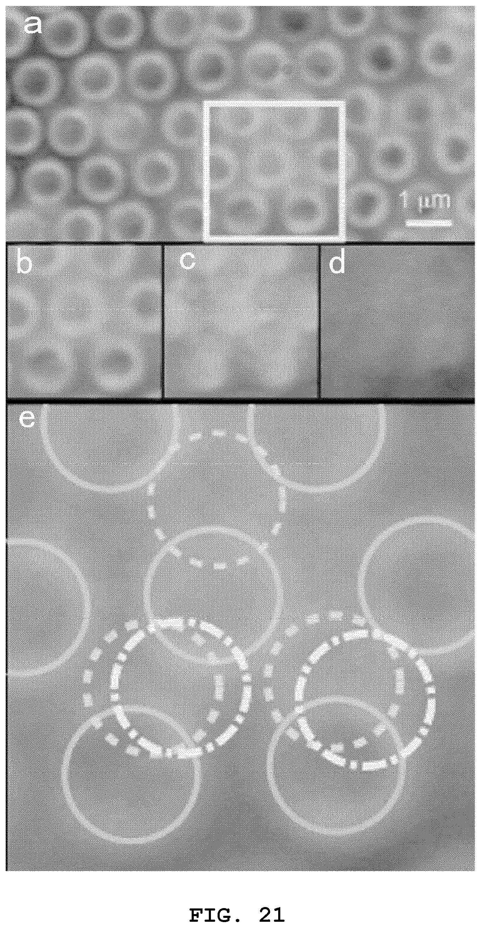

To a glass substrate surface-modified with APTES prepared in the same method as Example 1, lamination was performed by using the colloidal dispersions of the various titania particles having surfaces chemically modified. The particles in the first and third layers were dispersed and adsorbed in Milli-Q water to which no salt was added, and the particles in the second layer were adsorbed in a 100 $\mu$M aqueous sodium chloride solution. Optical micrographs of the first, second, and third layers are shown in FIG. 21. A photograph a is an image taken with the focal plane set in the first layer, and photographs b, c, and d are images of a region surrounded by the white line square in the photograph a when the focal plane was sequentially set in the first layer, the second layer, and the third layer. A photograph e shows outlines of the particles observed in the photographs b, c, and d added to the photograph d (the particles in the first layer are indicated by solid lines, the particles in the second layer are indicated by broken lines, and the particles in the third layer are indicated by dashed-dotted lines). From these photographs, arrangement having a regular tetrahedral shape was observed, and it was found that the diamond lattice structure was formed.

The present invention is not limited to the description of the embodiments and the examples of the invention. Variously modified forms are also included in the present invention to the extent that those skilled in the art are easily conceivable without departing from the scope of claims.

INDUSTRIAL APPLICABILITY

The colloidal particles in colloidal crystals of the present invention can have a particle diameter ranging from nanometer order to micrometer order. Since the arrangement structure thereof also has a spatial period of the same degree so that visible light is scattered and diffracted, the colloidal crystals can be used as an optical material. The colloidal crystals have a diamond lattice structure and therefore can be expected to be used as photonic crystals having a complete bandgap capable of confining light.

REFERENCE SIGNS LIST

S1: first layer forming step,
S2: second layer forming step,
S3: third layer forming step,
S21: base material preparation step,
S22: liquid layer forming step,
S23: single-layer structure growth step
1, 2, 3: particles,
21a, 21b: base material,
22: membrane filter,
23: liquid layer,
24: reservoir tank,
25: colloidal crystallization liquid,

26: reservoir tank,
27: charge adjusting liquid,
28: two-dimensional charged colloidal crystal.

**Claims**

**1.** A colloidal crystal having a diamond lattice structure, comprising:

a first layer in which a first plurality of particles are arranged to form a (111) plane of a face-centered cubic lattice structure;
a second layer in which a second plurality of particles are arranged on the first layer in contact with the first plurality of particles; and
a third layer in which a third plurality of particles are arranged on the second layer in contact with the second plurality of particles, wherein
the colloidal crystal comprises at least one layer of each of the first layer, the second layer and the third layer, or comprises a structure in which these layers are repeated one or more times.

**2.** The colloidal crystal according to claim 1, wherein an average value of an orientation order parameter $\Psi_3$ defined by Equation (1) is between 0.5 and 1, and wherein an average value of $R/\ell$ represented by Equation (2) is between 0 and 0.2 , wherein Equations (1) and (2) are:

$$\psi_3 = \frac{1}{3}\sum_{n=1}^{3}\left|e^{-3i\theta_n}\right| \quad \cdots (1)$$

$$R\,/\ell \quad \cdots (2)$$

,

wherein $\theta_n$ in Equation (1) denotes an angle formed by a vector from the center of a particle in the second layer toward a center of three particles in the first layer, and an arbitrary set reference axis;

wherein $\ell$ in Equation (2) denotes a length of one side of an equilateral triangle formed by particles of the first layer; and
wherein R in Equation (2) denotes a distance between a particle in the first layer and a particle in the second layer located thereon.

**3.** The colloidal crystal according to claim 1 or 2, comprising one layer of each of the first layer, the second layer, and the third layer.

**4.** The colloidal crystal according to any one of claims 1 to 3, wherein the first plurality of particles, the second plurality of particles, and the third plurality of particles are all composed of particles having an average particle diameter of 50 to 1000 nm.

**11.** A method for producing a colloidal crystal comprising:

forming a single layer structure of a first charged colloidal crystal on a substrate by bringing the substrate having a surface charge opposed to a surface charge of a first plurality of charged colloid particles into contact with a first colloidal dispersion in which the first plurality of charged colloid particles are dispersed in a dispersion medium, the first colloidal dispersion being capable of precipitating a colloidal crystal and having a volume percent of first charged colloidal particles of 15 to 19 %;
forming a single layer structure comprising a second plurality of charged colloidal particles on the first layer by bringing the substrate having the first layer formed thereon into contact with a second colloidal dispersion comprising the second plurality of charged colloidal particles having a surface charge opposed to the surface charge of the first plurality of charged colloidal particles; and
forming a single layer structure comprising a third plurality of charged colloidal particles on the second layer by bringing the substrate having the second layer formed thereon into contact with a third colloidal dispersion comprising the third plurality of charged colloidal particles having a surface charge opposed to the surface charge of the second plurality of charged colloidal particles.

**6.** The method for producing a colloidal crystal according to claim 5, wherein the first plurality of charged colloidal particles, the second plurality of charged colloidal particles, and the plurality of third charged colloidal particles all have a coefficient of variation of particle diameter of 20 % or less.

**7.** The method for producing a colloidal crystal according to claim 5 or 6, wherein the first plurality of charged colloidal particles, the second plurality of charged colloidal particles, and the third plurality of charged colloidal particles all have an average particle diameter of 50 nm to 1000 nm.

**8.** The method for producing a colloidal crystal according to any one of claims 5 to 7, wherein
the first layer forming step comprises:

a liquid layer forming step, wherein a liquid layer made of a colloidal dispersion is formed on the base material; and growing a single-layer structure of the colloidal crystal on the base material by diffusing a charge-adjusting liquid capable of setting the surface charge of the base material opposite to that of the charge of the first plurality of colloidal particles, from one side of the liquid layer.

**9.** The method for producing a colloidal crystal according to claim 8, wherein the base material is made of a material having a surface charge changing depending on ion concentration, and wherein
the charge adjusting liquid is an acid or a base capable of setting the sign of the surface charge of the base material opposite to that of the charge of the first colloidal particles.

**10.** The method for producing a colloidal crystal according to claim 8 or 9, wherein
the liquid layer forming step comprises:

preparing a charged colloidal dispersion in which the first plurality of colloidal particles are dispersed in a dispersion medium;
forming a liquid layer made of the charged colloidal dispersion on the base material; and
diffusing a colloidal crystallization preparation liquid capable of colloidal crystallization of the charged colloidal dispersion from one end side of the liquid layer.

FIG. 1

EP 4 046 962 A1

BCC  FCC  HCP

(1) Body-Centered
Cubic Lattice

(2) Face-Centered
Cubic Lattice

(3) Hexagonal
Close-Packed Lattice

FIG. 2

○ : particle in the 1st layer

● : particle in the 2nd layer

$b_n$ : 2D position vector

$\theta_n$ : angle with x-axis

$\Psi_3 = 1$ : center of a right triangle

$\Psi_3 = 0$ : completely random arrangement

FIG. 3

$R$ : center to center distance of a particle in the 2nd layer and a particle in the 3rd layer

$l$ : center to center distance of particles in the 1st layer

$R / l = 0$ : complete overlap

FIG. 4

FIG. 5

substrate

First Layer
Forming Step — S1

Second Layer
Forming Step — S2

Third Layer
Forming Step — S3

Colloidal Crystal Having
Diamond Lattice Structure

FIG. 6

FIG. 7

FCC lattice

diamond lattice

1st layer

2nd layer

(111)plane

3rd layer

FIG. 8

FIG. 9

FIG. 10

FIG. 11

Yukawa potential, $Z_1 = Z_3 = -10000$; $a_1 = a_2 = a_3 = (510/2)nm$

$Z_2 = +20000$  |  $Z_2 = +10000$  |  $Z_2 = +5000$  |  $Z_2 = +2000$

adsorbable area
$Cs < 9 \mu M$

adsorbable area
$Cs < 9 \mu M$

adsorbable area
$Cs < 9 \mu M$

adsorbable area
$5 \mu M < Cs < 9 \mu M$

FIG. 12

EP 4 046 962 A1

FIG. 13

FIG. 14

FIG. 15

FIG. 16

FIG. 17

FIG. 18

FIG. 19

FIG. 20

FIG. 21

**INTERNATIONAL SEARCH REPORT**

| International application No. |
| --- |
| PCT/JP2020/037967 |

A. CLASSIFICATION OF SUBJECT MATTER
B01J 13/00(2006.01)i
FI: B01J13/00 Z; C01B33/12 Z

According to International Patent Classification (IPC) or to both national classification and IPC

B. FIELDS SEARCHED

Minimum documentation searched (classification system followed by classification symbols)
C01B33/12; B01J13/00

| Documentation searched other than minimum documentation to the extent that such documents are included in the fields searched | |
| --- | --- |
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)
CAplus/REGISTRY (STN)JSTPlus/JMEDPlus/JST7580 (JDreamIII)

C. DOCUMENTS CONSIDERED TO BE RELEVANT

| Category* | Citation of document, with indication, where appropriate, of the relevant passages | Relevant to claim No. |
| --- | --- | --- |
| A | AOYAMA, Y. et al., "Two-Dimensional Nonclose-Packed Colloidal Crystals by the Electrostatic Adsorption of Three-Dimensional Charged Colloidal Crystals", Langmuir, (2019), vol. 35, no. 28, pp. 9194-9201, DOI:10.1021/acs.langmuir.9b00861, entire text | 1-10 |
| A | MESEGUER, F., "Review Colloidal crystals as photonic crystals", Colloids and Surfaces A: Physicochemical and Engineering Aspects, (2005), vol. 270-271, pp. 1-7, DOI:10.1016/j.colsurfa.2005.05.038, entire text | 1-10 |
| A | 山中淳平ほか，コロイド微粒子の自己集合による構造形成，高分子，(2018), vol. 67, no. 11, pp. 647-650, entire text, non-official translation (YAMANAKA, Junpei et al., "Structure formation by self-assembly of colloidal micro particles", High Polymers, Japan) | 1-10 |

☒ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 02 December 2020 (02.12.2020) | 22 December 2020 (22.12.2020) |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

International application No.

PCT/JP2020/037967

C (Continuation).   DOCUMENTS CONSIDERED TO BE RELEVANT

| Category* | Citation of document, with indication, where appropriate, of the relevant passages | Relevant to claim No. |
|---|---|---|
| A | DUCROT, E. et al., "Colloidal alloys with preassembled clusters and spheres", Nature Materials, (2017), vol. 16, pp. 652-658, entire text | 1-10 |
| A | WO 2014/070652 A1 (NEW YORK UNIVERSITY) 08 May 2014 (2014-05-08) claims, examples | 1-10 |

INTERNATIONAL SEARCH REPORT

Information on patent family members

International application No.

PCT/JP2020/037967

| Patent Documents referred in the Report | Publication Date | Patent Family | Publication Date |
|---|---|---|---|
| WO 2014/070652 A1 | 08 May 2014 | US 2015/0290611 A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **K. M. HO ; C. T. CHAN ; C. M. SOUKOULIS.** *Phys.Rev.Lett.,* 1990, vol. 65, 3152
- **M. MALDOVAN ; E. L.THOMAS.** *Nature Mater.,* 2004, vol. 3, 593
- **E.DUCROT ; M.HE ; G.YI ; D.J.PINE.** *Nature Mater.,* 2017, vol. 16, 652
- **A.M.KALSIN ; M.FIALKOWSKI ; M.PASZEWSKI ; S.K.SMOUKOV ; K.J.M.BISHOP ; B.A. GRZY-BOWSKI.** *Science,* 2006, vol. 312, 420
- **Y. AOYAMA ; A. TOYOTAMA ; T. OKUZONO ; J. YAMANAKA.** *Langmuir,* 2019, vol. 35, 9194
- **Y. NAKAMURA ; M. OKACHI ; A. TOYOTAMA ; T. OKUZONO ; J.YAMANAKA.** *Langmuir,* 2015, vol. 31, 13303